(19) Europäisches Patentamt

European Patent Office

Office européen des brevets

(11) **EP 0 450 418 B1**

(12) **EUROPÄISCHE PATENTSCHRIFT**

(45) Veröffentlichungstag und Bekanntmachung des Hinweises auf die Patenterteilung:
**13.03.1996 Patentblatt 1996/11**

(51) Int Cl.⁶: **H03K 9/08**, G08C 19/22

(21) Anmeldenummer: **91104454.3**

(22) Anmeldetag: **21.03.1991**

(54) **Einrichtung zum Übertragen eines pulsbreitenmodulierten elektrischen Eingangssignals**

Device for transmitting a pulse-width modulated electrical input signal

Dispositif pour transmettre un signal d'entrée électrique à modulation de largeur d'impulsion

(84) Benannte Vertragsstaaten:
**DE FR GB IT**

(30) Priorität: **04.04.1990 DE 4010908**

(43) Veröffentlichungstag der Anmeldung:
**09.10.1991 Patentblatt 1991/41**

(73) Patentinhaber: **SIEMENS AKTIENGESELLSCHAFT
D-80333 München (DE)**

(72) Erfinder:
• **Vogt, Hartmut, Dipl.-Ing.
W-8522 Herzogenaurach (DE)**
• **Schwesig, Günter, Dipl.-Ing. (FH)
W-8520 Erlangen (DE)**

(56) Entgegenhaltungen:
• **PATENT ABSTRACTS OF JAPAN Band 12, Nr. 225 (F-626) 25. Juni 1988 & JP-A-6308848**
• **PATENT ABSTRACTS OF JAPAN Band 5, Nr. 153 (E-076) 26. September 1981 & JP-A-56085959**

## Beschreibung

Einrichtung zum Übertragen eines pulsbreitenmodulierten elektrischen Eingangssignals

Die Erfindung bezieht sich auf eine Einrichtung zum Übertragen eines pulsbreitenmodulierten elektrischen Eingangssignals von einer Quelle des Signals über einen Transformator und eine Schwellwertschaltung an eine Auswerteschaltung für das Puls-Pausen-Verhaltnis des Signals, die ein analoges, dem Gleichanteil des Eingangssignals proportionales Ausgangssignal liefert.

Wenn Meßsignale galvanisch getrennt übertragen werden sollen, hat es sich als vorteilhaft erwiesen, diese Signale in Form von pulsbreitenmodulierten Signalen zu übertragen. Dazu sind handelsübliche Einrichtungen der eingangs genannten Art entwickelt worden.

Bei derartigen Einrichtungen kann es jedoch zu Verfälschungen des Puls-Pausen-Verhältnisses kommen, da zum einen die Signalform des pulspausenmodulierten Signals durch den einzuschleifenden Transformator modifiziert wird und da bei der Rückwandlung in ein Binärsignal die dazu erforderliche Schwellwertstufe ein nicht ideales Schaltverhalten aufweist.

Aufgabe der Erfindung ist es, eine Einrichtung der eingangs genannten Art so auszubilden, daß eine möglichst genaue Umsetzung des pulsbreitenmodulierten Eingangssignals in ein diesem proportionales analoges Ausgangssignal ermöglicht ist.

Gemäß der Erfindung wird diese Aufgabe dadurch gelöst, daß mit Hilfe einer zweiten Sekundärwicklung des Transformators ein gegenüber dem Signal an einer ersten Sekundärwicklung inverses Signal ermittelt wird und daß beide Signale jeweils am Steuereingang einer Schwellwertstufe zugeleitet werden, wobei beide Schwellwertstufen bei einer definierten ersten Spannung eine vorgebbare erste Ausgangsspannung und bei einer definierten zweiten Spannung eine vorgegebene zweite, der ersten entgegengesetzten Ausgangsspannung abgeben, wobei diese Ausgangsspannungen von der Versorgungsspannung der Schwellwertstufen abhängen und wobei der Gleichanteil der ersten Ausgangsspannung das Ausgangssignal bestimmt und über einen mit integralem Verhalten Regler, dem die Summe der Gleichanteile der Ausgangsspannungen zugeleitet wird, die Versorgungsspannung der Schwellwertstufen im Sinne einer Eliminierung des Summensignals geregelt wird.

Eine vorteilhafte Ausbildung der Erfindung ist dadurch gekennzeichnet, daß beide Schwellwertstufen integrale Bestandteile einer Schwellwertschaltung sind. Dadurch, daß beide Schwellwertschaltungen damit ein weitgehend identisches elektrisches Verhalten aufweisen, kann die Qualität der gesamten Umsetzung noch mal gesteigert werden.

Ein Ausführungsbeispiel der Erfindung ist in der Zeichnung dargestellt und wird im folgenden näher erläutert. Dabei zeigen:

FIG 1    eine handelsübliche Schaltung,
FIG 2    dieser zugeordnete Signalverläufe,
FIG 3    die erfindungsgemäße Schaltung und
FIG 4    dieser zugeordnete Signalverläufe.

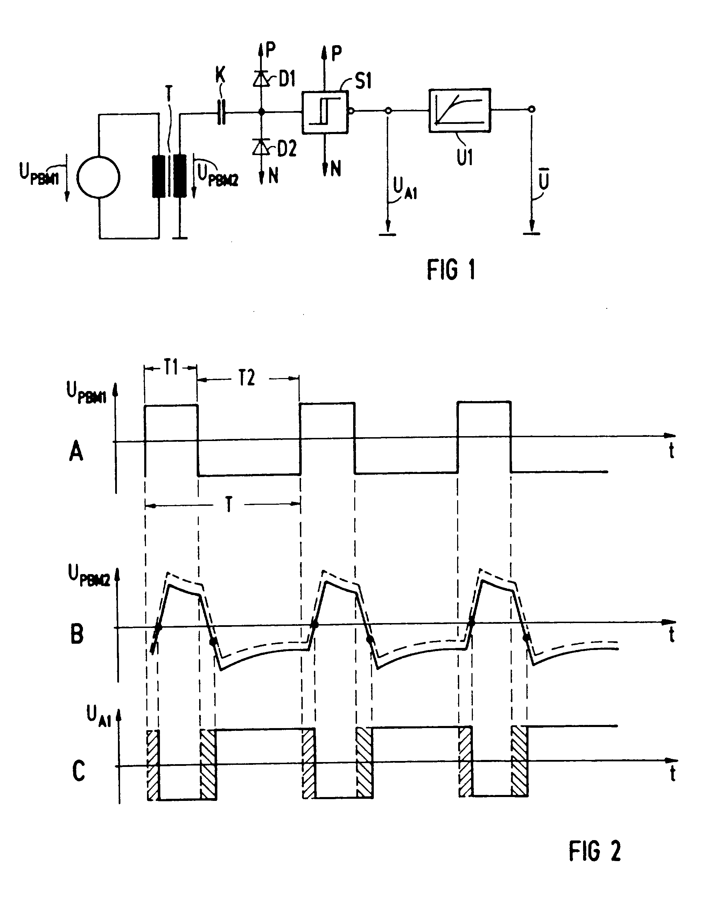

In der Darstellung gemäß FIG 1 ist eine Quelle für pulsbreitenmodulierte Signale $U_{PBM1}$ gezeigt, wobei diese Signale der Primärseite eines Transformators TR1 zugeleitet werden. Am Ausgang des Transformators TR1 steht dann eine Spannung $U_{PBM2}$ an, die zum einen auf Massepotential bezogen ist und die zum anderen über einen Koppelkondensator K an den Verbindungspunkt zweier Dioden D1 und D2 geleitet ist, wobei die Diode D1 mit ihrer Kathode an ein positives Potential P und die Diode D2 mit ihrer Anode an ein negatives Potential N geschaltet ist. Die Anode der Diode D1 und die Kathode der Diode D2 führen an den Eingang einer invertierernden Schwellwertstufe S1, die ebenfalls an das positive Potential P und das negative Potential N geschaltet ist, so daß dann, wenn die Eingangsspannung an der Schwellwertstufe S1 eine vorgegebene positive Spannung überschreitet das negative Potential N als Ausgangssignal an der Schwellwertstufe S1 anliegt, während dann, wenn das Eingangssignal an der Schwellwertstufe S1 einen vorgegebenen negativen Wert unterschreitet, das positive Potential P am Ausgang der Schwellwertstufe S1 vorliegt. Die somit resultierende Ausgangsspannung ist in der Darstellung mit $U_{A1}$ bezeichnet. Diese Ausgangsspannung $U_{A1}$ wird einem Umsetzer U1 mit Tiefpaßverhalten zugeleitet, der aus dem pulsbreitenmodulierten Signal am Ausgang der Schwellwertstufe S1 ein diesem proportionales analoges Ausgangssignal $\overline{U}$ formt.

Zum Verständnis der Schaltung gemäß FIG 1 wird auf die zeitsynchron gestalteten Diagramme A bis C von FIG 2 verwiesen. Im Diagramm A ist dabei über die Zeit t der Verlauf der Spannung $U_{PBM1}$ gezeigt. Es möge dabei jeweils für eine Zeitspanne T1 ein positives Potential und für eine Zeitspanne T2 ein negatives Potential vorliegen. Die resultierende Periodendauer ist dabei als T bezeichnet.

Im korrespondierenden Zeitmaßstab ist im Diagramm B der Verlauf der Spannung $U_{PBM2}$ gestrichelt dargestellt. Ersichtlich ist dabei, daß die Spannungs-Zeit-Flächen im positiven und negativen Bereich aufgrund der Transformatorbedingung gleich sind. Um hier eine Annäherung an den Signalverlauf gemäß Diagramm A zu erreichen, wird mit Hilfe der Anordnung aus Kondensator K und Diode D1 und D2 der Spannungsverlauf so beeinflußt, daß die Spannungswerte von $U_{PBM2}$ im positiven und negativen Bereich egalisiert werden, wodurch sich der in der Darstellung gemäß Diagramm B mit einer durchgezogenen Linie gezeigte Verlauf ergibt.

Im Diagramm C ist nunmehr das Ausgangssignal der Schwellwertstufe S1 gezeigt, wobei Schaltpunkte der Schwellwertstufe S1 angenommen sind, wie diese im Diagramm B durch dicke Punkte angedeutet sind.

Die aufsteigende Flanke der Spannung $U_{PBM1}$ führt damit jeweils zu einer abfallenden Flanke der Ausgangsspannung $U_{A1}$. Die fallende Flanke des Signals $U_{PBM1}$ führt jeweils zu einer steigenden Flanke des Signals $U_{A1}$. Entscheidend für das Verständnis zur vorliegenden Erfindung ist es jedoch, daß die verzögerungszeiten dieser beiden Vorgänge nicht identisch sind. Der Darstellung im Diagramm C ist dies dadurch entnehmbar, daß die von links nach rechts steigend schraffierte Fehlfläche nicht der von links nach rechts fallende dargestellten Fehlfläche entspricht. Dieser Sachverhalt führt im angenommenen Beispiel dazu, daß ein zu großes Verhältnis T1 : T2 am Eingang des Umsetzers U1 vorliegt und demzufolge das Signal $\bar{U}$ ebenfalls zu groß ist.

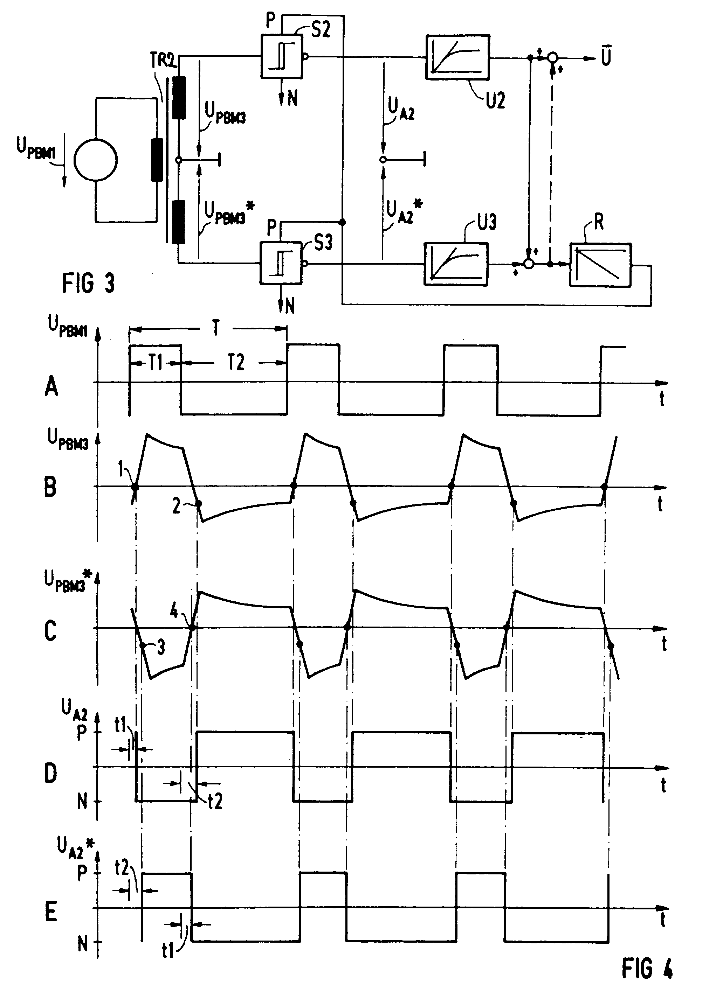

In der Darstellung gemäß FIG 3 ist eine Schaltungsanordnung gezeigt, die prinzipiell Merkmale der Schaltung gemäß FIG 1 beinhaltet. Auch hierbei möge die pulsbreitenmodulierte Spannung $U_{PBM1}$ einem Transformator, in diesem Fall den Transformator TR2 zugeleitet werden, an dessen einer Wicklung eine der Spannung $U_{PBM2}$ entsprechende Spannung $U_{PBM3}$ ansteht, die einer Schwellwertstufe nach Art der Schwellwertstufe S1, in diesem Fall der Schwellwertstufe S2 zugeleitet werden möge, bei der jedoch eine Variation der positiven Versorgungsspannung P möglich ist, auf die im folgenden noch eingegangen wird. Am Ausgang der Schwellwertstufe S2 liegt dann ebenso wie bei der Schwellwertstufe S1 ein pulsbreitenmoduliertes Ausgangssignal $U_{A2}$ an, das einem Umsetzer U2 nach Art des Umsetzers U1 zugeleitet wird, so daß am Ausgang des Umsetzers U2 dann ebenfalls das dann ein Gleichsignal $\bar{U}$ abgreifbar ist.

Auf die mögliche Einfügung einer der Schaltungsanordnung aus Kondensator K und Dioden D1 und D2 entsprechenden Schaltung ist der Übersichtlichkeit halber verzichtet worden.

Bei der Erfindung ist nun allerdings am Transformator TR2 eine der Spannung $U_{PBM3}$ inverse Spannung $U_{PBM3*}$ über eine zweite Wicklung gegenüber Masse abgreifbar, die einer weiteren Schwell wertstufe S3 zugeleitet wird, die in ihrem Aufbau der Schwellwertstufe S2 möglichst genau entspricht und die deshalb möglichst mit ihr auf einem Chip integriert ist. Das Ausgangssignal der Schwellwertstufe S3 gelangt an den Eingang eines Umsetzers U3, der prinzipiell dem Umsetzer U1 entspricht, wobei das Ausgangssignal der Schwellwertstufe S3 mit $U_{A2*}$ bezeichnet ist.

Das erfindungsgemäße Konzept zum Ausregeln des eingangs geschilderten Fehlers sieht nun vor, daß die Ausgangssignale des Umsetzers U2 und U3 miteinander addiert werden und über einen Regler R die positive Versorgungsspannung der Schwellwertstufen S2 und S3 so beeinflussen, daß das Summensignal ausgeregelt wird. Um diesen Vorgang anschaulich zu beschreiben, wird auf die Diagramme A bis E von FIG 4 verwiesen. Die Diagramm A bis E sind dabei zeitlich synchron zueinander dargestellt.

Im Diagramm A von FIG 4 ist der Verlauf des Signals $U_{PBM1}$ gezeigt, das in seinem Verlauf dem Signal gemäß Diagramm A von FIG 2 entspricht. Im Diagramm B ist die Spannung $U_{PBM3}$ am Ausgang der ersten Wicklung des Transformators TR2 gezeigt. Im Diagramm C ist die dazu inverse Ausgangsspannung des Transformators TR2, die Spannung $U_{PBM3*}$ dargestellt. Aufgrund der Tatsache, daß die Schwellwertstufen der inversen Zweige aber nicht invers, sondern identisch in ihrem Schaltverhalten ausgebildet sind, führt dies auf Schaltpunkte, wie diese mit 1, 2, 3 und 4 für den Zeitabschnitt T in den Diagrammen B und C gezeigt sind.

Eine ansteigende Flanke des Signals $U_{PBM1}$ führt stets auf eine fallende Flanke des Signals $U_{A2}$, wobei eine Zeitverzögerung t1 erfolgt, die abfallende Flanke des Signals $U_{PBM1}$ führt stets zu einer ansteigenden Flanke des Signals $U_{A2}$ mit einer Zeitverzögerung von t2. Für die Ausgangsspannung $U_{A2*}$ ergeben sich folgende Verhältnisse. Eine ansteigende Flanke des Signals $U_{PBM1}$ löst zeitverzögert um eben die Zeit t2 eine ansteigende Flanke für das Signal $U_{A2*}$ aus, während eine fallende Flanke des Signals $U_{PBM1}$ zu einer fallenden Flanke des Signals $U_{A2*}$ führt, wobei dabei die Verzögerungszeit eben t1 ist.

Aus den Diagrammen D und E ist somit leicht ersichtlich, daß die Dauer des jeweils negativen Signalbereichs des Ausgangssignals $U_{A2}$, beispielsweise für die Zeit T1 des Signals $U_{PBM1}$, um die Zeit t2 -t1 zu groß ist. Für die Spannung $U_{A2*}$ ergibt sich dazu kontroverser Sachverhalt, daß nämlich die durch die positiven Impulse des pulsbreitenmodulierten Signals $U_{PBM1}$ ausgelösten, ebenfalls positiven Impulse um eben die Differenz t2 -t1 zu schmal sind.

Bei der Erfindung wird nunmehr eine Mittelung der Signale gemäß den Diagrammen D und E vorgenommen, die im Ausführungsbeispiel durch eine Addition der Ausgangssignale der Umsetzer U2 und U3 erfolgt. Das gemittelte Signal ist dem eingangs anhand von FIG 2 geschilderten Fehler direkt proportional und könnte prinzipiell den Wert des Signals $\bar{U}$ durch eine Überlagerung kompensieren, was in der Schaltung gemäß FIG 3 gestrichelt angedeutet ist. In diesem Fall könnte auf den im folgenden eingeführten Regler R und die Variation der positiven Versorgungsspannung für die Schwellwertstufen S2 und S3 verzichtet werden.

Das geschilderte Regelungsprinzip hat sich jedoch als schaltungstechnisch äußerst leicht beherrschbar erwiesen. Im bevorzugten Ausführungsbeispiel wird daher das Summensignal der Ausgangsspannungen der Umsetzer U2 und U3 dazu dem Regler R mit integralem Verhalten zugeleitet, der die Versorgungsspannung der Schwellwertstufen S2 und S3 so variiert, daß das Summensignal der Ausgangsspannungen der Umsetzer U2 und U3 ausgeregelt wird. Das im eingeregelten Zustand vorliegende Signal $\bar{U}$ entspricht dann in seiner Größe dem Puls-Pausen-Verhältnis $U_{PBM1}$.

Da beim Ausführungsbeispiel die negativem Impulse gegenüber den positiven Impulsen beim Signal $U_{A2}$ zu breit wären, würde demzufolge die positive Versorgungsspannung P erhöht (bzw. die negative Versorgungsspannung würde erniedrigt).

Aus Gründen eines Schutzres der Schwellwertstufen gegen Über- bzw. Unterspannungen, könnte das Ausgangssignal des Reglers R bedarfsweise begrenzt werden.

## Patentansprüche

1. Einrichtung zum Übertragen eines pulsbreitenmodulierten elektrischen Eingangssignals von einer Quelle des Signals über einen Transformator und eine Schwellwertschaltung an eine Auswerteschaltung für das Puls-Pausen-Verhältnis des Signals die ein analoges, dem Gleichanteil des Eingangssignals proportionales Ausgangssignal liefert, **dadurch gekennzeichnet**, daß mit Hilfe einer zweiten Sekundärwicklung des Transformators (TR2) ein gegenüber dem Signal ($U_{PBM3}$) an einer ersten Sekundärwicklung inverses Signal ($U_{PBM3*}$) ermittelt wird und daß beide Signale jeweils dem Steuereingang einer Schwellwertstufe (S2,S3) zugeleitet werden, wobei beide Schwellwertstufen (S2,S3) bei einer definierten ersten Spannung am besagten Steuereingang eine vorgebbare erste Ausgangsspannung (P) und bei einer definierten zweiten Spannung am besagten Steuereingang eine vorgegebene zweite, der ersten entgegengesetzten Ausgangsspannung (N) abgeben, wobei diese Ausgangsspannungen von der Versorgungsspannung der Schwellwertstufen abhängen und wobei der Gleichanteil der ersten Ausgangsspannung ($U_{A2}$) das Ausgangssignal ($\bar{U}$) bestimmt und über einen Regler (R) mit integralem Verhalten, dem die Summe der Gleichanteile der Ausgangsspannungen ($U_{A2}$, $U_{A3}$) zugeleitet wird, die Versorgungsspannung der Schwellwertstufen (S2,S3) im Sinne einer Eliminierung des Summensignals geregelt wird.

2. Einrichtung nach Anspruch 1, **dadurch gekennzeichnet**, daß beide Schwellwertstufen (S2,S3) integrale Bestandteile einer Schwellwertschaltung sind.

## Claims

1. Device for transmitting a pulse-width modulated electrical input signal from a source of the signal, via a transformer and a threshold value circuit arrangement, to an evaluating circuit arrangement for the mark-to-space ratio of the signal that supplies an analog output signal which is proportional to the direct component of the input signal, characterised in that a signal ($U_{PBM3*}$) which is inverse with respect to the signal ($U_{PBM3}$) at a first secondary winding of the transformer (TR2), is ascertained with the aid of a second secondary winding of the transformer (TR2) and in that both signals are fed to the respective control input of a threshold value stage (S2, S3), wherein both threshold value stages (S2, S3) deliver a preselectable first output voltage (P) in the case of a defined first voltage at said control input and a preselected second output voltage (N), which is opposed to the first, in the case of a defined second voltage at said control input, wherein these output voltages are dependent upon the supply voltage of the threshold value stages and wherein the direct component of the first output voltage ($U_{A2}$) determines the output signal ($\bar{U}$), and the supply voltage of the threshold value stages (S2, S3) is controlled, for the purpose of eliminating the summation signal, by way of a controller (R) which has integral action and to which the sum of the direct components of the output voltages ($U_{A2}$, $U_{A3}$) is fed.

2. Device according to claim 1, characterised in that both threshold value stages (S2, S3) are integral components of a threshold value circuit arrangement.

## Revendications

1. Dispositif de transmission d'un signal d'entrée électrique, modulé par largeur d'impulsions, d'une source du signal par l'intermédiaire d'un transformateur et d'un circuit à seuil à un circuit d'exploitation du rapport durée d'impulsion - durée de pause du signal, lequel fournit un signal de sortie analogique proportionnel à la composante continue du signal d'entrée, caractérisé par le fait qu'un signal ($U_{PBM3*}$), inverse du signal ($U_{PBM3}$) présent dans le premier enroulement secondaire, est déterminé à l'aide d'un second enroulement secondaire du transformateur (TR2), les deux signaux sont envoyés chacun à l'entrée de commande d'un étage à seuil (S2,S3), les deux étages à seuil (S2,S3) fournissant, dans le cas où une première tension définie est présente à ladite entrée de commande, une première tension de sortie (P) pouvant être prescrite, et dans le cas où une seconde tension définie est présente à ladite entrée de commande, une seconde tension de sortie prescrite (N), qui est opposée à la première tension de sortie, ces tensions de sortie dépendant de la tension d'alimentation des étages à seuil, tandis que la composante continue de la première tension de sortie ($U_{A2}$) détermine le signal de sortie ($\bar{U}$) et que la tension d'alimentation des étages à seuil (S2,S3) est, en vue d'une suppression du signal somme, réglée par l'intermédiaire d'un régulateur (R), qui a un comportement intégral et auquel est envoyée la somme des composantes continues des tensions de sortie ($U_{A2}$, $U_{A3}$).

**2.** Dispositif suivant la revendication 1, caractérisé par le fait que les deux étages à seuil (S2,S3) font partie intégrante d'un circuit à seuil.

FIG 1

FIG 2

FIG 3

FIG 4

$U_{PBM1}$

$U_{PBM3}$

$U_{PBM3}*$

$U_{A2}$

$U_{A2}*$

$\bar{U}$

TR2

S2

S3

U2

U3

R

P

N

A

B

C

D

E

T

T1

T2

t1

t2